# EUROPEAN PATENT SPECIFICATION

(11) **EP 0 465 808 B1**
(45) Date of publication and mention of the grant of the patent: **29.07.1998**
(21) Application number: 91108469.7
(22) Date of filing: 24.05.1991
(51) Int. Cl.: G06F 11/20

(54) **Variable size set associative DRAM redundancy scheme**
Assoziatives DRAM-Redundanzschema mit variabler Satzgrösse
Schéma de redondance associatif de DRAM avec grandeur de groupe variable

(30) Priority: 19.06.1990 US 540074
(43) Date of publication of application: 15.01.1992
(73) Proprietor: TEXAS INSTRUMENTS INCORPORATED, Dallas Texas 75265 (US)
(72) Inventor: Tran, Hiep V., Carrollton, Texas 75007 (US)
(74) Representative: Leiser, Gottfried, Dipl.-Ing.

(56) References cited:
- EP-A- 29 322
- EP-A- 178 950
- EP-A- 249 903
- US-A- 4 380 066

## Description

### FIELD OF THE INVENTION

This invention is in the field of integrated circuits and is specifically directed to a memory and a method of memory cell replacement according of the preamble of independent claims 1 and 7, respectively, which are known from EP-A-0 249 903.

### BACKGROUND OF THE INVENTION

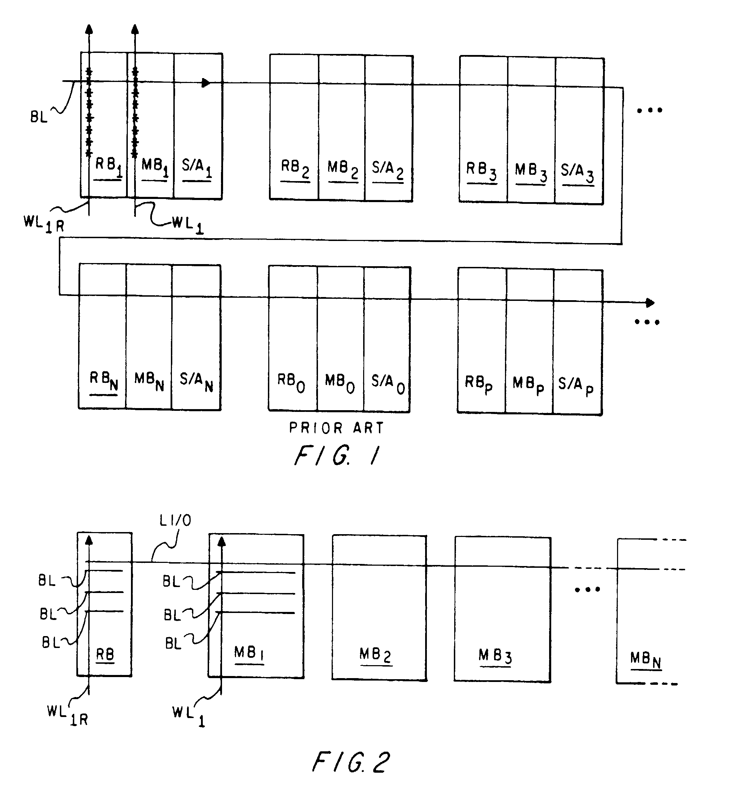

Figure 1 illustrates a schematic drawing of a prior art dynamic random access memory (DRAM) redundancy scheme which includes each memory block, labelled MB with an identifying subscript, and a plurality of redundant blocks of memory, RB, each associated with a memory block and carrying the same subscript. Each redundant block of memory RB and its associated memory block MB share bit lines (each bit line represent as BL). A plurality of sense amplifiers is also shown in figure 1 with each sense amplifier S/A (hereinafter referred to as sense amp) lying adjacent to and carrying the same subscript as its associated memory block. Redundant blocks of memory serve to provide alternate memory service. For instance, if word line WL₁ or a memory cell along word line WL₁ in memory block MB₁ is defective, word line WL_{1R} in redundant memory block RB₁ is used along with its row (illustrated as vertical columns) of memory cells (each asterisk representing a memory cell).

US Patent No. 4,380,066 discloses a defect tolerant memory which comprises a redundant memory with multiple levels which uses a randomless method to store redundant data from all chips of the main memory. A mask memory contains the addresses of defective cells in the main memory. A received address command is checked against the addresses stored in the mask memory to see if correspondence occurs. The mask memory then generates a bit pointer for a bit correction unit which corresponds to the position of a defective bit in a retrieved word. The bit correction unit then replaces data in the bit positions of the word corresponding to defective cells with data retrieved from the redundant memory. However, access times are slow since the received addresses of each word must be checked against the addresses stored in the mask memory.

EP-A-0 249 903 teaches the provision of memory cells of a separate redundancy array for replacing defective memory cells of the main array. An exchange controller is programmable to detect a specific row address signal indicating the row address of a defective memory cell in the main array. Where memory cells of the main array are defective, the exchange controller inhibits the selection operation of the row decoder and selects a row of memory cells in the redundancy array.

It is an object of the invention to provide a new and improved such memory and a corresponding method of memory cell replacement involving improved access times.

It is still another object of the invention to provide a method for using a redundancy array to replace cells from multiple blocks of a memory array.

It is still a further object of the invention to provide a redundancy method which avoids requirement of a redundant array in a one-to-one correspondence with each block of a main memory array.

These and other objects of the invention together with the features and advantages thereof will become apparent from the following detailed specification when read together with the accompanying drawings in which applicable reference numerals have been carried forward.

### SUMMARY OF THE INVENTION

Accordingly, the present invention provides a memory device as mentioned in the beginning having the features of the characterizing part of claim 1.

The foregoing objects of the invention are accomplished by a redundancy scheme wherein a redundant array of memory cells are divided into a series of sets. Each set is addressed by a portion of an address corresponding to a location in main memory. Each decoder from a group of decoders receives a selected address to be read from or written to. In connection with the determination of memory elements needing replacement, one or more of the decoders enables cells from associated redundant sets.

One block of redundant memory services a plurality of memory blocks from main memory using a common local input/output line. Preferably, the redundant block is relatively smaller in size than each main memory block.

Each decoder, set to flag a particular address for replacement, selects one or more redundant rows of memory from a set of the redundant array according to a portion of the current address. Each decoder is assigned memory replacement via designated sets from the redundant array.

The present invention further provides a method of memory cell replacement as mentioned in the beginning having the features of the characterizing part of claim 7.

### BRIEF DESCRIPTION OF THE DRAWINGS

Figure 1 illustrates a schematic drawing of a prior art dynamic random access memory (DRAM) redundancy scheme.

Figure 2 illustrates a schematic drawing of a first preferred embodiment of the invention's DRAM redundancy scheme.

Figure 3 illustrates a diagram of a first preferred layout of the invention implementing a 64 megabit DRAM with exploded views of selected components.

Figure 4 illustrates a diagram of a second preferred layout alternative to that shown in figure 3 for the invention implementing a 64 megabit DRAM.

Figure 5 illustrates a diagram of one possible scheme showing the use of the signal bits in selecting word lines for refresh.

Figure 6 illustrates a block diagram of the row redundancy scheme.

### DETAILED DESCRIPTION OF THE INVENTION

Figure 2 illustrates a schematic drawing of a first preferred embodiment of the invention's DRAM redundancy scheme. As shown, only one redundant block of memory RB is required for a plurality of memory blocks. Redundant block of memory RB has its own independent bit lines (each labeled BL) unlike that of the prior art in which bit lines of the redundant block and its associated memory block are shared. Here, local input/output (L I/O) data line is shared by redundant block of memory RB and a plurality of memory blocks MB. If there is a defect associated with word line WL₁ in memory block MB₁, then word line WL_{1R} from the redundant block is used along with its associated memory cells in redundant block RB. Alternatively, any word line and memory cells from any of the other blocks can be replaced through the use of redundant block RB. The number of wordlines and associated circuitry (i.e. memory cells) which can be corrected depends on the number of word lines and associated circuitry in the redundant block. Thus, if the redundant block has 5 rows of memory cells, 5 wordlines and their associated cells can be corrected from any of the memory blocks.

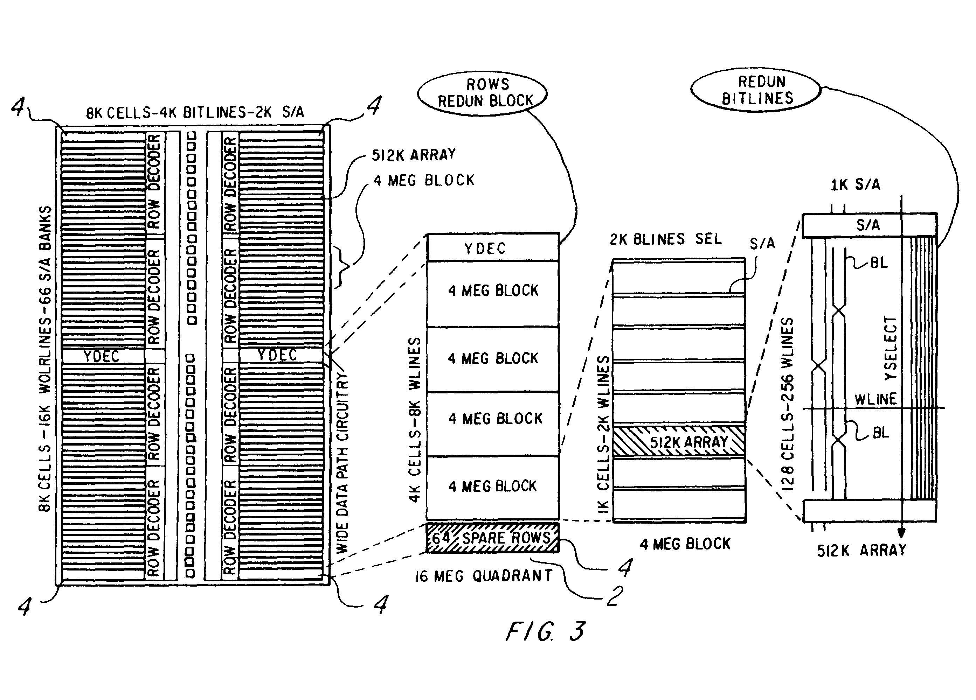

Figure 3 illustrates a diagram of a first preferred layout of the invention implementing a 64 megabit DRAM with exploded views of selected components. There are 8000 (8k) memory cells, 16,000 (16k) word lines, and 2000 (2k) sense amps (S/A) in the 64 meg DRAM of figure 3 . As illustrated, an exploded view of a section along the dashed line details one 16 megabit quadrant 2. There are 4000 (4K) memory cells and 8000 (8K) word lines in each 16 meg quadrant. Note that a block of redundant rows 4 exists for each 16 megabit quadrant of memory. In this example, there are 64 redundant rows of memory in each block of redundant rows 4. Each 16 megabit quadrant 2 is partitioned into four 4 megabit (4 meg) memory blocks with each block including four 512 kilobit (512k) memory arrays. As shown, another exploded view of memory along dashed lines details a 4 meg block of memory. For ease of illustration, only one 512k array is labeled along with a section of sense amplifiers S/A. A section of sense amplifiers abuts each array. There are 1000 (1k) memory cells and 2000 (2k) word lines in each 4 meg block. The number of bit lines in a 4 meg block is on the order of 2000. The labeled 512k array and its associated sense amplifiers S/A are exploded into a more detailed view in which bit lines BLs are of the twisted variety. There are 128 memory cells and 256 word lines in each 512k array. Word line WLINE and bit line YSELECT indicate a word line and a bit line respectively, selected by a respective row decoder and column decoder YDEC. The intersection of a bit line with a word line as shown indicates the location of a chosen memory cell. The small section of closely spaced vertical lines labeled REDUN BITLINES indicates the bit lines for the redundant memory cells. Bond pads 3 for the address, control, and input/output (I/O) are represented by the small squares down the middle of chip 2. The location of wide data path circuitry is indicated as shown.

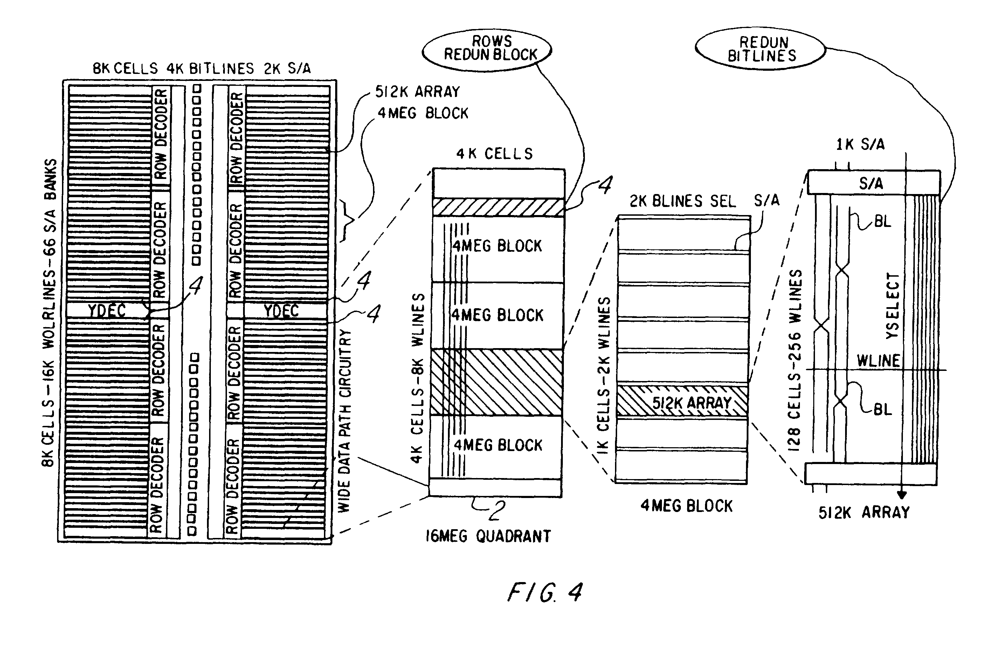

A second preferred layout alternative to that shown in figure 3 for the invention implementing a 64 megabit DRAM is illustrated in the diagram in figure 4. The position of the redundant blocks differs from that shown in figure 3. Note that the redundant blocks are near the column decoders (YDEC). This positioning of the redundant blocks near the column decoders can increase the operating speed of the memory.

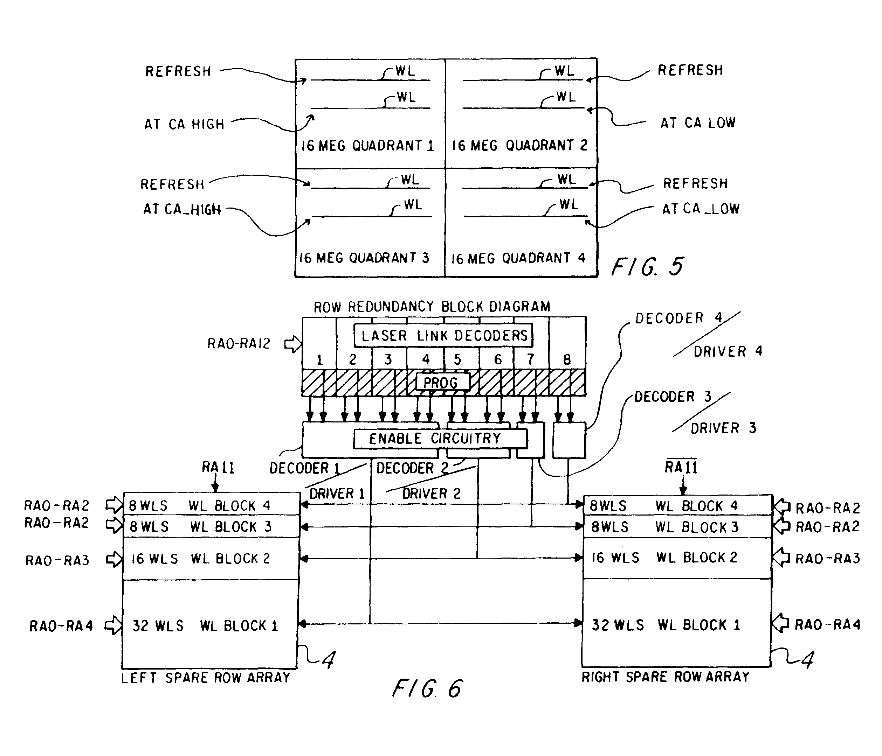

Memory cells of a DRAM must be refreshed to prevent loss of data. Generally, this is accomplished by the word line of a cell being energized so as to allow the cell's bit line to reinsert data to the cell via a sense amplifier. Refresh of a memory cell is required after reading data out of the cell. Refresh is also routinely required to prevent loss of memory storage through capacitor leakage. The refresh operation of the preferred embodiment of the 64 meg DRAM is such that 8k of memory cells are refreshed at a time. This translates into four word lines (2k memory cells on each word line) on the 64 meg chip being refreshed at the same time. Column address program (CA PROG) provides a signal bit either CA or CA_ which allows the selection of four word lines for refresh including any word lines from which the data of an associated cell is desired. Figure 5 illustrates a diagram of one possible scheme showing the use of the signal bits in selecting word lines for refresh. Memory cells of two word lines from a pair of diagonally positioned 16 meg quadrants are refreshed. For instance, when signal bit CA is logic high, signal bit CA_, its complement, is logic low. Consequently, in the scheme shown in figure 5, two word lines in 16 meg quadrant 1 are refreshed along with two word lines in 16 meg quadrant 4. Alternatively, when signal bit CA_ is logic high, its complement, signal bit CA is logic low, thereby resulting in two word lines in both 16 meg quadrants 2 and 3 being refreshed. In either of the cases given above concerning the logic states of signal bits CA and CA_, one of the word lines for a cell selected for refresh will be a word line for a cell selected for reading information therefrom. Refresh of the cells of the selected word line occurs after the selected cell information has been read. Should the row address of a selected cell correspond to an address identified by circuitry (not shown) as having a defective word line, then replacement of the cell with a cell of a redundant word line takes place in accordance with the following description.

Figure 6 illustrates a block diagram of the row redundancy scheme. As shown, redundant rows 4, referenced respectively as left and right spare row arrays are each divided into 2 groups of 8 word lines (WLs), 1 group of 16 WLs, and 1 group of 32 WLs. Enable circuitry comprising decoders labeled 1, 2, 3, and 4, enables redundant word line blocks labeled 1, 2, 3, and 4 to provide replacement for word line rows of memory within the 4 meg blocks based on signals received from a plurality of laser link decoders. Alternatively, instead of decoders, enable circuitry can comprise drivers, whereby redundant row selection in spare row arrays is determined by the plurality of laser link decoders. Although only 8 laser link decoders are illustrated in figure 6, fewer or more may be used. The redundant memory along word lines are addressable by a portion of the address from the non redundant or rather main memory array. Thus, although the current address from main memory is for instance, 12 bits long, the redundant memory can for instance be addressed by 2 to 4 bits which can reflect the least significant 2 to 4 bits in the 12 bit long current address. Word line block 1 comprises 32 word lines addressable by row addresses RA0 to RA4. Word line block 2 comprises 16 word lines addressable by row addresses RA0 to RA3. Word line block 3 comprises 8 word lines addressable by row addresses RA0 to RA2. Word line block 4 comprises 8 word lines addressable by row addresses RA0 to RA2. As a consequence of the above discussed addressability, should for instance, rows 3-10 of a first 4 meg block be defective, either of laser link decoders 1 to 4 could provide replacement of these defective rows with the available 32 word line rows of redundant memory in redundant block 1 addressed by RA0-RA4. If, for instance, in addition to the defective rows 3-10 of the first block, rows 3-10 of a second 4 meg block are defective, decoders 5 or 6 can provide replacement of the defective rows in the second block with redundant rows from the available 16 word line rows of redundant memory in redundant block 2 addressed by RA0-RA3. Further, if rows 3-10 of a third 4 meg block are additionally defective, decoder 7 can provide replacement of the defective rows in the third block with redundant rows from the available 8 word line rows of redundant memory in redundant block 3 addressed by RA0-RA2. If in addition to the defective rows 3-10 in the first, second and third blocks, rows 3-10 in a fourth 4 meg block of memory are defective, decoder 8 can provide replacement of the defective rows in the fourth block of memory with redundant rows from the available 8 word line rows of redundant memory in redundant block 4 addressed by RA0-RA2. As shown, redundant word line blocks are in either a right or left spare row array. A right or left spare row selection is determined by row address RA11 and its complement RA11_ such that a high signal on an address bit indicates selection of a corresponding spare row array. An optimal replacement scheme for the memory can be determined by a computer program 9 (represented in figure 6 as PROG) using linear programming or other techniques. Alternatively, a computer program is not necessary to implement this aspect of the invention. Therefore, a human operator can determine the order of replacement.

Although the invention has been described in detail herein with reference to its preferred embodiment, it is to be understood that this description is by way of example only and is not to be construed in a limiting sense. It is to be further understood that numerous changes in the details of the embodiments of the invention, and additional embodiments of the invention, will be apparent to, and may be made by persons of ordinary skill in the art having reference to this description. For instance, although the foregoing invention has been described with regard to a DRAM, it may be used as a redundancy scheme for any memory including read only memories and static random access memories. It is contemplated that all such changes and additional embodiments are within the scope of the invention as claimed below.

## Claims

1. A memory device comprising;
a main array of memory cells arranged in a plurality (2) of memory blocks (4 MEG BLOCK);
a redundancy array (RB) of memory cells arranged in a plurality of sets (4; 64 SPARE ROWS);
enabling circuitry (ENABLE CIRCUITRY) including a plurality of decoders (DECODER 1, etc.), each decoder being arranged for enabling, dependent upon an applied address (RA0-RA12), memory cells in the redundancy array (RB) for replacing defective memory cells of the main array;
and characterized in that each set (4; 64 SPARE ROWS) of memory cells of the redundancy array (RB) is associated with a plurality (2) of said memory blocks (4 MEG BLOCKS), each set (4; 64 SPARE ROWS) of memory cells of the redundancy array (RB) including a plurality of wordlines arranged in wordline groups (WL BLOCK 4, etc.), each wordline group (WL BLOCK 4, etc.) being associated with one of said plurality (2) of memory blocks (4 MEG BLOCKS) and addressable by a portion (RA0-RA2; RA0-RA4) of the applied address (RA0-RA12), and the enabling circuitry (ENABLE CIRCUITRY) being arranged for enabling memory cells in a plurality of wordlines in a wordline group (WL BLOCK 4, etc.) according to a sub-portion of said portion (RA0-RA2; RA0-RA4) of the applied address (RA0-RA12).

2. The memory device as claimed in claim 1, wherein the enabling circuitry is actuable to enable more than one wordline group (4).

3. The memory device as claimed in claim 1 or claim 2, wherein the redundancy array (RB) shares a common input/output line with the main array.

4. The memory device as claimed in any preceding claim, wherein the memory cells of the redundancy array (RB) are capable of replacing either one memory block or multiple memory blocks (MB₁-MB_{N}) of the main array.

5. The memory of any preceding claim, wherein the number of memory cells in one wordline group is non-uniform with respect to at least one other wordline group of the redundancy array (RB).

6. The memory of any preceding claim, wherein each decoder (7) is responsive to correspondence between a predetermined address and the selected address such that memory cells of a wordline group in the redundancy array (RB) are enabled.

7. A method of memory cell replacement comprising;
providing a main array of memory cells arranged in a plurality of memory blocks (4 MEG BLOCK);
providing a redundancy array (RB) of memory cells arranged in a plurality (2) of sets (4; 64 SPARE ROWS);
providing enabling circuitry (ENABLE CIRCUITRY) including a plurality of decoders (DECODER 1, etc.), each decoder being arranged for enabling, dependent upon an applied address (RA0-RA12), memory cells in the redundancy array (RB) for replacing defective cells of the main array;
characterized in that said method further comprises;
associating each set of wordline groups (WL BLOCK 4, etc.) with a plurality of said memory blocks (4 MEG BLOCK) of the main array, each set (4; 64 SPARE ROWS) of memory cells of the redundancy array (RB) including a plurality of wordlines arranged in wordline groups (WL BLOCK 4, etc.);
associating each wordline group (WL BLOCK 4, etc.) with one of said plurality (2) of memory blocks (4 MEG BLOCKS);
addressing each of said wordline groups (WL BLOCK 4, etc.) with a portion (RA0-RA2; RA0-RA4) of the applied address (RA0-RA12); and
enabling memory cells in a plurality of wordlines in a wordline group (WL BLOCK 4, etc.) with said enabling circuitry (ENABLE CIRCUITRY) according to a sub-portion of said portion (RA0-RA2; RA0-RA4) of the applied address (RA0-RA12).

## Patentansprüche

1. Speichervorrichtung, mit:
einer Hauptmatrix aus Speicherzellen, die in mehreren (2) Speicherblöcken (4 MEG BLOCK) angeordnet sind;
einer Redundanzmatrix (RB) aus Speicherzellen, die in mehreren Gruppen (4; 64 SPARE ROWS) angeordnet sind;
einer Freigabeschaltungsanordnung (ENABLE CIRCUITRY), die mehrere Decodierer (DECODER 1, usw.) enthält, wovon jeder so beschaffen ist, daß er abhängig von einer eingegebenen Adresse (RA0-RA12) Speicherzellen in der Redundanzmatrix (RB) freigibt, um defekte Speicherzellen in der Hauptmatrix zu ersetzen;
und dadurch gekennzeichnet, daß jede Gruppe (4; 64 SPARE ROWS) aus Speicherzellen der Redundanzmatrix (RB) mehreren (2) der Speicherblöcke (4 MEG BLOCKS) zugeordnet ist, jede Gruppe (4; 64 SPARE ROWS) aus Speicherzellen der Redundanzmatrix (RB) mehrere Wortleitungen enthält, die in Wortleitungsgruppen (WL BLOCK 4, usw.) angeordnet sind, wobei jede Wortleitungsgruppe (WL BLOCK 4, usw.) einem der mehreren (2) Speicherblöcke (4 MEG BLOCKS) zugeordnet ist und durch einen Abschnitt (RA0-RA2; RA0-RA4) der eingegebenen Adresse (RA0-RA12) adressierbar ist, und die Freigabeschaltungsanordnung (ENABLE CIRCUITRY) so beschaffen ist, daß sie Speicherzellen in mehreren Wortleitungen in einer Wortleitungsgruppe (WL BLOCK 4, usw.) entsprechend einem Unterabschnitt des Abschnitts (RA0-RA2; RA0-RA4) der eingegebenen Adresse (RA0-RA12) freigibt.

2. Speichervorrichtung nach Anspruch 1, wobei die Freigabeschaltungsanordnung so betreibbar ist, daß sie mehr als eine Wortleitungsgruppe (4) freigibt.

3. Speichervorrichtung nach Anspruch 1 oder Anspruch 2, wobei die Redundanzmatrix (RB) eine Eingangs-/Ausgangsleitung mit der Hauptmatrix gemeinsam nutzt.

4. Speichervorrichtung nach irgendeinem vorangehenden Anspruch, wobei die Speicherzellen der Redundanzmatrix (RB) entweder einen Speicherblock oder mehrere Speicherblöcke (MB₁-MB_{N}) der Hauptmatrix ersetzen können.

5. Speicher nach irgendeinem vorangehenden Anspruch, wobei die Anzahl von Speicherzellen in einer Wortleitungsgruppe in bezug auf wenigstens eine weitere Wortleitungsgruppe der Redundanzmatrix (RB) unterschiedlich ist.

6. Speicher nach irgendeinem vorangehenden Anspruch, wobei jeder Decodierer (7) auf die Entsprechung zwischen einer vorgegebenen Adresse und der gewählten Adresse anspricht, so daß Speicherzellen einer Wortleitungsgruppe in der Redundanzmatrix (RB) freigegeben werden.

7. Verfahren zur Speicherzellenersetzung, enthaltend:
Vorsehen einer Hauptmatrix aus Speicherzellen, die in mehreren Speicherblöcken (4 MEG BLOCK) angeordnet sind;
Vorsehen einer Redundanzmatrix (RB) aus Speicherzellen, die in mehreren (2) Gruppen (4; 64 SPARE ROWS) angeordnet sind;
Vorsehen einer Freigabeschaltungsanordnung (ENABLE CIRCUITRY), die mehrere Decodierer (DECODER 1, usw.) enthält, wovon jeder so beschaffen ist, daß er abhängig von einer eingegebenen Adresse (RA0-RA12) Speicherzellen in der Redundanzmatrix (RB) freigibt, um defekte Zellen der Hauptmatrix zu ersetzen;
dadurch gekennzeichnet, daß das Verfahren ferner enthält:
Zuordnen jeder Gruppe von Wortleitungsgruppen (WL BLOCK 4, usw.) an mehrere der Speicherblöcke (4 MEG BLOCK) der Hauptmatrix, wobei jede Gruppe (4; 64 SPARE ROWS) aus Speicherzellen der Redundanzmatrix (RB) mehrere Wortleitungen enthält, die in Wortleitungsgruppen (WL BLOCK 4, usw.) angeordnet sind;
Zuordnen jeder Wortleitungsgruppe (WL BLOCK 4, usw.) an einen von mehreren (2) Speicherblöcken (4 MEG BLOCKS);
Adressieren jeder der Wortleitungsgruppen (WL BLOCK 4, usw.) mit einem Abschnitt (RA0-RA2; RA0-RA4) der eingegebenen Adresse (RA0-RA12); und
Freigeben von Speicherzellen in mehreren Wortleitungen in einer Wortleitungsgruppe (WL BLOCK 4, usw.) mit der Freigabeschaltungsanordnung (ENABLE CIRCUITRY) entsprechend einem Unterabschnitt des Abschnitts (RA0-RA2; RA0-RA4) der eingegebenen Adresse (RA0-RA12).

## Revendications

1. Dispositif de mémoire comprenant :
un réseau principal de cellules de mémoire disposées selon une pluralité (2) de blocs de mémoire (BLOCS DE 4 MEGABITS) ;
un réseau de redondance (RB) de cellules de mémoire disposées suivant une pluralité d'ensembles (4 ; 64 RANGEES DE RESERVE) ;
un circuit de validation (CIRCUIT DE VALIDATION) comprenant une pluralité de décodeurs (DECODEUR 1, etc.), chaque décodeur étant disposé de manière à valider, en fonction d'une adresse appliquée (RA0-RA12), des cellules de mémoire dans le réseau de redondance (RB) pour remplacer des cellules de mémoire défectueuses du réseau principal ;
et caractérisé en ce que chaque ensemble (4 ; 64 RANGEES DE RESERVE) de cellules de mémoire du réseau de redondance (RB) est associé à une pluralité (2) desdits blocs de mémoire (BLOCS DE 4 MEGABITS), chaque ensemble (4 ; 64 RANGEES DE RESERVE) de cellules de mémoire du réseau de redondance (RB) comprenant une pluralité de lignes de transmission de mots disposées suivant des groupes de lignes de transmission de mots (BLOCS DE LIGNES DE TRANSMISSION DE MOTS 4, etc.), chaque groupe de lignes de transmission de mots (BLOCS DE LIGNES DE MOTS 4, etc.) étant associée à un bloc de mémoire de ladite pluralité (2) de blocs de mémoire (BLOCS DE 4 MEGABITS) et adressables par une partie (RA0-RA2 ; RA0-RA4) de l'adresse appliquée (RA0-RA12), et le circuit de validation (CIRCUIT DE VALIDATION) étant agencé de manière à valider des cellules de mémoire dans une pluralité de lignes de mots dans un groupe de lignes de mots (BLOCS DE LIGNES DE MOTS 4, etc.) conformément à une sous-partie de ladite partie (RA0-RA2 ; RA0-RA4) des adresses appliquées (RA0-RA12).

2. Dispositif de mémoire selon la revendication, dans lequel le circuit de validation peut être activé de manière à valider plus d'un groupe de lignes de mots (4).

3. Dispositif de mémoire selon la revendication 1 ou la revendication 2, dans lequel le réseau de redondance (RB) partage, avec le réseau principal, une ligne d'entrée/sortie commune.

4. Dispositif de mémoire selon l'une des revendications précédentes, dans lequel les cellules de mémoire du réseau de redondance (RB) peuvent remplacer n'importe quel bloc de mémoire ou de multiples blocs de mémoires (MB₁-MB_{N}) du réseau principal.

5. Mémoire selon l'une quelconque des revendications précédentes, dans laquelle le nombre de cellules de mémoire dans un groupe de lignes de mots n'est pas uniforme en rapport avec au moins un autre groupe de lignes de mots du réseau de redondance (RB).

6. Mémoire selon l'une quelconque des revendications précédentes, dans laquelle chaque décodeur (7) est apte à répondre à une correspondance entre une adresse prédéterminée et l'adresse sélectionnée de sorte que les cellules de mémoire d'un groupe de lignes de mots dans le réseau de redondance (RB) sont validées.

7. Procédé de remplacement d'une cellule de mémoire comprenant :
le fait de prévoir un réseau principal de cellules de mémoire disposées dans une pluralité de blocs de mémoire (BLOCS DE 4 MEGABITS) ;
le fait de prévoir un réseau de redondance (RB) de cellules de mémoire disposé suivant une pluralité (2) d'ensembles (4 ; 64 RANGEES DE RESERVE) ;
le fait de prévoir un circuit de validation (CIRCUIT DE VALIDATION) comprenant une pluralité de décodeurs (DECODEUR 1, etc.), chaque décodeur étant disposé de manière à valider, en fonction d'une adresse appliquée (RA0-RA12), des cellules de mémoire dans le réseau de redondance (RB) pour remplacer des cellules de mémoire défectueuses du réseau principal ; et
caractérisé en ce que ledit procédé comprend en outre :
l'association de chaque ensemble de groupes de lignes de mots (BLOCS DE LIGNES DE MOTS 4, etc.) à une pluralité desdits blocs de mémoire (BLOCS DE 4 MEGABITS) du réseau principal, chaque ensemble (4 ; 64 RANGEES DE RESERVE) de cellules de mémoire du réseau de redondance (RB) comprenant une pluralité de lignes de mots disposées suivant des groupes de lignes de mots (BLOC DE LIGNES DE MOTS 4, etc.) ;
l'association de chaque groupe de lignes de mots (BLOCS DE LIGNES DE MOTS 4, etc.) avec un bloc de ladite pluralité (2) de blocs de mémoire (BLOCS A 4 MEGABITS) ;
l'adressage de chacun desdits groupes de lignes de mots (BLOCS DE LIGNES DE MOTS 4, etc.) avec une partie (RA0-RA2 ; RA0-RA4) de l'adresse appliquée (RA0-RA12) ; et
la validation de cellules de mémoire dans une pluralité de lignes de mots dans un groupe de lignes de mots (BLOCS DE LIGNES DE MOTS 4, etc.) avec ledit circuit de validation (CIRCUIT DE VALIDATION) conformément à une sous-partie de ladite partie (RA0-RA2; RA0-RA4) de l'adresse appliquée (RA0-RA12).
